# EUROPÄISCHE PATENTANMELDUNG

(11) **EP 3 136 599 A1**
(43) Veröffentlichungstag der Anmeldung: **01.03.2017**
(21) Anmeldenummer: 15182563.5
(22) Anmeldetag: 26.08.2015
(51) Int. Cl.: H03K 17/0412

(54) **SCHALTUNGSANORDNUNG MIT FELDEFFEKTTRANSISTOR UND ANSTEUERUNG ÜBER INDUKTIVITÄT**

(71) Anmelder: Siemens Aktiengesellschaft, 80333 München (DE)
(72) Erfinder: Hieke, Tobias, 90491 Nürnberg (DE)

(57) **Zusammenfassung**

Eine Schaltungsanordnung weist einen Feldeffekttransistor (1) auf, der einen Source-Anschluss (2), einen Gate-Anschluss (3) und einen Drain-Anschluss (4) aufweist. Der Source-Anschluss (2) bildet ein Referenzpotenzial. An den Source-Anschluss (2) oder an den Drain-Anschluss (4) ist eine Nutzlast (5) angeschlossen. Der Gate-Anschluss (3) ist über eine Steuerleitung (6) mit einer Steuerschaltung (7) verbunden. Der Gate-Anschluss (3) wird von der Steuerschaltung (7) über die Steuerleitung (6) alternierend mit dem Referenzpotenzial und einem Steuerpotenzial beaufschlagt. In der Steuerleitung (6) ist ein Basiswiderstand (8) angeordnet. Dem Basiswiderstand (8) ist eine Induktivität (9) derart parallelgeschaltet, dass die Induktivität (9) zumindest dann wirksam ist, wenn der Gate-Anschluss (3) von der Steuerschaltung (7) mit dem Referenzpotenzial beaufschlagt wird.

## Beschreibung

Die vorliegende Erfindung geht aus von einer Schaltungsanordnung mit einem Feldeffekttransistor,
- wobei der Feldeffekttransistor einen Source-Anschluss, einen Gate-Anschluss und einen Drain-Anschluss aufweist,
- wobei der Source-Anschluss ein Referenzpotenzial bildet, an den Source-Anschluss oder an den Drain-Anschluss eine Nutzlast angeschlossen ist und der Gate-Anschluss über eine Steuerleitung mit einer Steuerschaltung verbunden ist,
- wobei der Gate-Anschluss von der Steuerschaltung über die Steuerleitung alternierend mit dem Referenzpotenzial und einem Steuerpotenzial beaufschlagt wird,
- wobei in der Steuerleitung ein Basiswiderstand angeordnet ist.

Feldeffekttransistoren werden üblicherweise von einer Steuerschaltung geschaltet. Zum Schutz der Steuerschaltung vor Überlastung muss der maximal über die Steuerleitung fließende Treiberstrom jedoch auf einen zulässigen Wert von beispielsweise 1 A begrenzt werden. Zu diesem Zweck ist in der Steuerleitung der Basiswiderstand angeordnet.

Bei dem gesteuerten Feldeffekttransistor beginnt der Schaltvorgang sowohl beim Einschalten des Feldeffekttransistors (d.h. beim Wechsel der Steuerspannung vom Referenzpotenzial zum Steuerpotenzial) als auch beim Ausschalten des Feldeffekttransistors (d.h. beim Wechsel der Steuerspannung vom Steuerpotenzial zum Referenzpotenzial) dann, wenn die sogenannte Threshold-Spannung erreicht wird und das sogenannte Miller-Plateau durchlaufen wird. Das Miller-Plateau liegt üblicherweise bei ca. 3 V (relativ zum Referenzpotenzial). Beim Einschalten des Feldeffekttransistors ist dieses Verhalten in der Regel unproblematisch, da die Steuerspannung relativ groß ist, beispielsweise 15 V relativ zum Referenzpotenzial. Dadurch wird im Ergebnis bewirkt, dass ein hinreichend großer Strom in das Gate des Feldeffekttransistors fließt und dort die erforderliche Spannung zum Schalten des Feldeffekttransistors aufbaut. Beim Ausschalten ist das Verhalten prinzipiell umgekehrt. Die Differenz zwischen der an der von der Steuerschaltung ausgegebenen, an der Steuerleitung anstehenden Spannung (d.h. in diesem Fall der Referenzspannung) und dem Miller-Plateau ist jedoch schon recht gering. Es steht also nur eine relativ kleine, den Stromfluss treibende Spannung zur Verfügung. Das Einschalten des Feldeffekttransistors ist daher erheblich schneller zu bewirken als das Ausschalten.

Zur Behebung dieser Problematik ist im Stand der Technik bekannt, dem Basiswiderstand einen Zusatzwiderstand parallelzuschalten, wobei der Zusatzwiderstand nur dann wirksam wird, wenn der Gate-Anschluss von der Steuerschaltung mit dem Referenzpotenzial beaufschlagt wird. Beispielsweise kann zu diesem Zweck dem Zusatzwiderstand eine entsprechend gepolte Diode oder ein entsprechend angesteuerter Halbleiterschalter vor- oder nachgeschaltet sein.

In der Regel führt diese Vorgehensweise zu guten Ergebnissen. Probleme ergeben sich jedoch in Fällen, in denen Feldeffekttransistoren mit großen Gatekapazitäten Verwendung finden. Derartige Feldeffekttransistoren werden insbesondere in Netzteilen mit großen Eingangsspannungen oder großer Eingangsleistung benötigt.

Es ist denkbar, dennoch ein schnelles Ausschalten des Feldeffekttransistors dadurch zu bewirken, dass die Treiberschaltung für eine höhere Stromtragfähigkeit ausgelegt wird. Dies beseitigt jedoch nicht das grundlegende Problem, dass das Einschalten des Feldeffekttransistors erheblich schneller bewirkt wird als das Ausschalten des Feldeffekttransistors. Ferner führt dies zu zusätzlichem Kosten, da eine spezielle Steuerschaltung benötigt wird.

Es ist weiterhin denkbar, die Steuerschaltung derart zu modifizieren, dass sie zu Beginn des Ausschaltvorgangs - insbesondere während des Durchlaufens des Miller-Plateaus - eine negative Spannung an das Gate ausgibt. Dies erfordert jedoch eine entsprechende Modifikation der Steuerschaltung, so dass diese zusätzlich zum Referenzpotenzial und zum Steuerpotenzial auch ein weiteres Potenzial an die Steuerleitung anlegen kann, das - bezogen auf das Referenzpotenzial - im Vergleich zum Steuerpotenzial ein negatives Vorzeichen aufweist. Auch diese Vorgehensweise ist daher mit Kosten, oftmals sogar mit erheblichen Kosten verbunden.

Die Aufgabe der vorliegenden Erfindung besteht darin, eine Schaltungsanordnung der eingangs genannten Art derart zu modifizieren, dass auch bei Feldeffekttransistoren mit großen Gatekapazitäten sowohl ein schnelles Einschalten als auch ein schnelles Ausschalten zuverlässig bewirkt werden können.

Die Aufgabe wird durch eine Schaltungsanordnung mit den Merkmalen des Anspruchs 1 gelöst. Vorteilhafte Ausgestaltungen der erfindungsgemäßen Schaltungsanordnung sind Gegenstand der abhängigen Ansprüche 2 bis 7.

Erfindungsgemäß wird eine Schaltungsanordnung der eingangs genannten Art dadurch ausgestaltet, dass dem Basiswiderstand eine Induktivität derart parallelgeschaltet ist, dass die Induktivität zumindest dann wirksam ist, wenn der Gate-Anschluss von der Steuerschaltung mit dem Referenzpotenzial beaufschlagt wird.

Bei der Induktivität handelt es sich nicht lediglich um die intrinsische, unvermeidbare Induktivität der Steuerleitung, sondern um eine explizite, gezielt eingebrachte Induktivität. Die Induktivität kann beispielsweise durch ein diskretes Bauelement, durch Übertrager oder durch Leiterschleifen realisiert sein.

In Ausnahmefällen ist es möglich, dass die Induktivität auch dann wirksam ist, wenn der Gate-Anschluss von der Steuerschaltung mit dem Steuerpotenzial beaufschlagt wird. In der Regel ist die Induktivität jedoch ausschließlich dann wirksam, wenn der Gate-Anschluss von der Steuerschaltung mit dem Referenzpotenzial beaufschlagt wird. Zu diesem Zweck ist üblicherweise mit der Induktivität ein weiteres Schaltungselement in Reihe geschaltet, das die entsprechende Funktionalität bewirkt.

Es ist möglich, dass das weitere Schaltelement als Diode ausgebildet sein. Alternativ hierzu ist es möglich, dass das weitere Schaltungselement als Halbleiterschalter ausgebildet ist. In diesem Fall wird der Halbleiterschalter von der Steuerschaltung leitend geschaltet, wenn der Gate-Anschluss von der Steuerschaltung mit dem Referenzpotenzial beaufschlagt wird, und nichtleitend geschaltet, wenn der Gate-Anschluss von der Steuerschaltung mit dem Steuerpotenzial beaufschlagt wird.

Es ist möglich, dass dem Basiswiderstand ausschließlich die Induktivität parallel geschaltet ist. Alternativ ist es möglich, dass der Induktivität ein erster Zusatzwiderstand in Reihe geschaltet ist und/oder ein zweiter Zusatzwiderstand parallelgeschaltet ist.

In manchen Fällen ist es von Vorteil, wenn der Source-Anschluss und der Gate-Anschluss über einen Kondensator kapazitiv miteinander gekoppelt sind. Bei diesem Kondensator handelt es sich nicht um die intrinsisch vorhandene Kapazität zwischen Gate und Source, sondern um ein eigenständiges Bauteil, das zusätzlich zu der intrinsischen Kapazität zwischen Gate und Source vorhanden ist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: eine erfindungsgemäße Schaltungsanordnung,
- FIG 2: eine Schaltungsanordnung des Standes der Technik,
- FIG 3: einen Einschaltvorgang,
- FIG 4: einen Ausschaltvorgang bei der Schaltungsanordnung des Standes der Technik,
- FIG 5: einen Ausschaltvorgang bei der erfindungsgemäßen Schaltungsanordnung und
- FIG 6: eine Modifikation der erfindungsgemäßen Schaltungsanordnung.

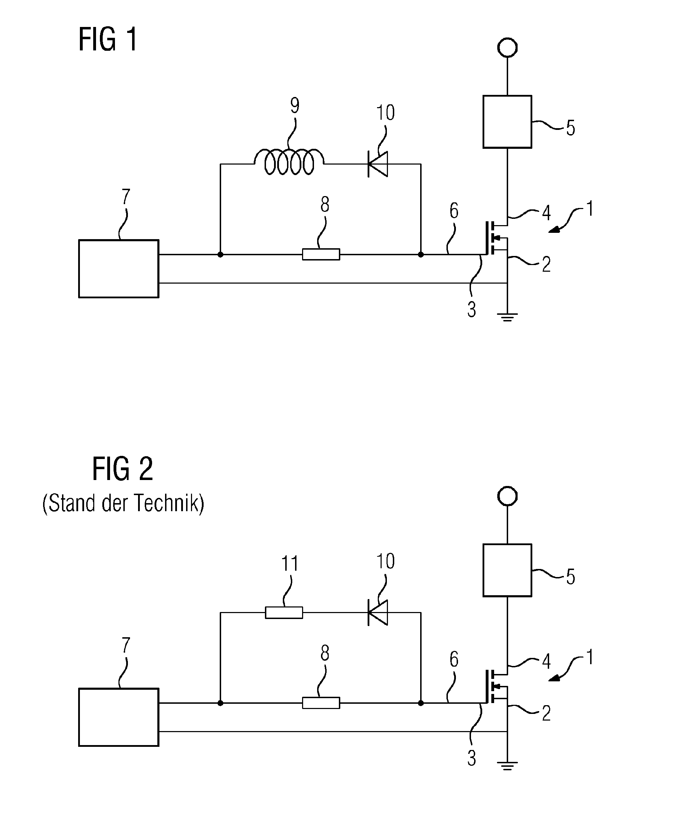

Gemäß FIG 1 weist eine Schaltungsanordnung einen Feldeffekttransistor 1 auf. Der Feldeffekttransistor kann beispielsweise als MOSFET oder als IGBT ausgebildet sein. Der Feldeffekttransistor 1 weist einen Source-Anschluss 2, einen Gate-Anschluss 3 und einen Drain-Anschluss 4 auf. Bei einem IGBT werden der Source-Anschluss 2 und der Drain-Anschluss 4 üblicherweise als Emitter und als Kollektor bezeichnet. Aus Gründen der durchgängigen und konsistenten Bezeichnung der Komponenten werden nachfolgend jedoch durchgehend die Begriffe Source-Anschluss und Drain-Anschluss verwendet.

Der Source-Anschluss 2 ist mit einem definierten Referenzpotenzial verbunden. Bei dem Referenzpotenzial kann es sich beispielsweise um Masse oder um Erde handeln. An den Drain-Anschluss 4 ist eine Nutzlast 5 angeschlossen. Die Nutzlast 5 kann prinzipiell beliebig ausgestaltet sein, beispielsweise als Sperrwandler. Der Gate-Anschluss 3 ist über eine Steuerleitung 6 mit einer Steuerschaltung 7 verbunden. Die Steuerschaltung 7 ist üblicherweise eine vollständig konfigurierte, kommerziell erhältliche Schaltung. Rein beispielhaft sei auf die Steuerschaltungen UCCx8C4y (x = 2 oder 3, y = 1 bis 5) der Firma Texas Instruments verwiesen. Von der Steuerschaltung 7 wird der Gate-Anschluss 3 über die Steuerleitung 6 alternierend mit dem Referenzpotenzial und einem Steuerpotenzial von beispielsweise 15 V beaufschlagt. Wenn und solange der Gate-Anschluss 3 mit dem Referenzpotenzial beaufschlagt wird, ist der Feldeffekttransistor 1 gesperrt. Wenn und solange der Gate-Anschluss 3 mit dem Steuerpotenzial beaufschlagt wird, ist der Feldeffekttransistor 1 leitend.

Im Falle der obenstehend erläuterten Ausgestaltungen bildet der Source-Anschluss 2 dadurch ein Referenzpotenzial, dass er direkt an ein globales Referenzpotenzial (Erde oder Masse) angeschlossen ist. Alternativ kann die Nutzlast 5 an den Source-Anschluss 2 angeschlossen sein. In diesem Fall bildet der Source-Anschluss 2 ein eigenständiges, lokales Referenzpotenzial. In diesem Fall wird dieses Referenzpotenzial über eine entsprechende, in FIG 1 dargestellte Hilfsleitung der Steuerschaltung 7 zugeführt. Die Steuerschaltung 7 wird in diesem Fall potenzialgetrennt betrieben. Beispielsweise kann sie über Transformatoren mit elektrischer Energie versorgt werden. Ein Steuersignal für die Steuerschaltung 7 kann der Steuerschaltung 7 beispielsweise über einen Optokoppler zugeführt werden. Es sind jedoch auch andere Möglichkeiten zur Energieversorgung und Datenübertragung möglich.

Unter Umständen kann weiterhin dem Source-Anschluss ein Shunt-Widerstand zur Strommessung nachgeschaltet sein. In diesem Fall kann das Referenzpotenzial alternativ vor oder nach dem Shunt-Widerstand abgegriffen werden.

Die Steuerschaltung 7 darf nur Ströme bis zu einem Maximalstrom treiben. Anderenfalls besteht die Gefahr, dass die Steuerschaltung 7 beschädigt wird. Der Maximalstrom kann beispielsweise im Bereich von 1 A liegen. Zum Schutz der Steuerschaltung 7 vor einem zu hohen Strom ist daher in der Steuerleitung 6 ein Basiswiderstand 8 angeordnet. Der Basiswiderstand 8 begrenzt den beim Schalten des Feldeffekttransistors 1 auftretenden Strom auf zulässige Werte. Dem Wortteil "Basis" kommt hierbei kein weitergehender Bedeutungsinhalt zu. Er dient lediglich dazu, den Widerstand 8 sprachlich von später noch einzuführenden Widerständen unterscheiden zu können.

Dem Basiswiderstand 8 ist eine Induktivität 9 parallelgeschaltet. Die Parallelschaltung ist derart, dass die Induktivität 9 zumindest dann wirksam ist, wenn der Gate-Anschluss 3 von der Steuerschaltung 7 mit dem Referenzpotenzial beaufschlagt wird. Vorzugsweise ist hierbei entsprechend der Darstellung in FIG 1 mit der Induktivität 9 ein weiteres Schaltungselement 10 in Reihe geschaltet. Das weitere Schaltungselement 10 kann entsprechend der Darstellung in FIG 1 als Diode ausgebildet sein. Das weitere Schaltungselement 10 bewirkt, dass die Induktivität 9 ausschließlich dann wirksam ist, wenn der Gate-Anschluss 3 von der Steuerschaltung 7 mit dem Referenzpotenzial beaufschlagt wird. Denn nur dann wird die Diode leitend. Anderenfalls sperrt sie.

Alternativ zur Verwendung einer Diode könnte das weitere Schaltungselement als Halbleiterschalter ausgebildet sein. In diesem Fall wird der Halbleiterschalter von der Steuerschaltung leitend geschaltet, wenn der Gate-Anschluss 3 von der Steuerschaltung 7 mit dem Referenzpotenzial beaufschlagt wird. Wenn der Gate-Anschluss 3 von der Steuerschaltung 7 mit dem Steuerpotenzial beaufschlagt wird, wird der Halbleiterschalter hingegen von der Steuerschaltung 7 nichtleitend geschaltet.

Unter Umständen kann mit dem Basiswiderstand 8 ein weiteres, in FIG 1 nicht dargestelltes Schaltungselement in Reihe geschaltet sein, beispielsweise eine Diode. Dieses weitere Schaltungselement bewirkt, dass der Basiswiderstand 8 ausschließlich dann wirksam ist, wenn der Gate-Anschluss 3 von der Steuerschaltung 7 mit dem Steuerpotenzial beaufschlagt wird. In der Regel ist jedoch kein derartiges weiteres Schaltelement vorhanden.

Die erfindungsgemäße Schaltungsanordnung von FIG 1 korrespondiert somit weitgehend mit der in FIG 2 dargestellten Schaltungsanordnung des Standes der Technik. Der Unterschied besteht darin, dass bei der erfindungsgemäßen Schaltungsanordnung dem Basiswiderstand 8 die Induktivität 9 parallelgeschaltet ist bzw. anstelle des Basiswiderstands 8 wirkt, während bei der Schaltungsanordnung des Standes der Technik dem Basiswiderstand 8 anstelle der Induktivität 9 ein weiterer Widerstand 11 - Zusatzwiderstand 11 - parallelgeschaltet ist.

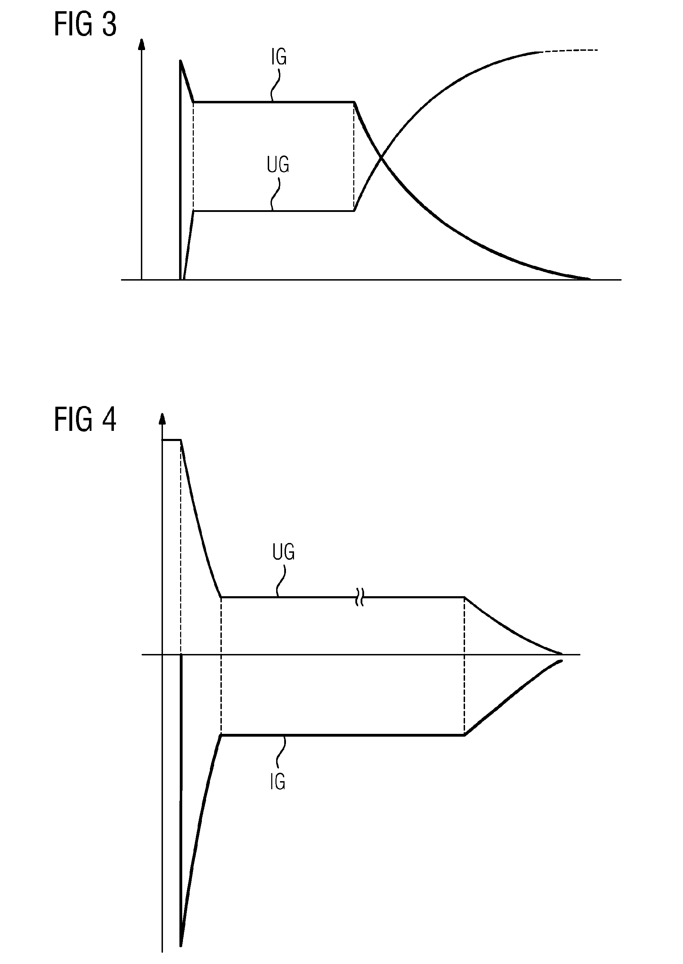

Beim Einschalten des Feldeffekttransistors 1 ergeben sich keine Unterschiede zwischen der erfindungsgemäßen Schaltungsanordnung und der Schaltungsanordnung des Standes der Technik. Insbesondere steigt entsprechend der Darstellung in FIG 3 die am Gate-Anschluss 3 anstehende Spannung UG sehr schnell auf das Miller-Plateau an, verharrt dort eine Zeitlang und steigt dann exponentiell auf das von der Steuerschaltung 7 ausgegebene Steuerpotenzial an. Der über die Steuerleitung 6 fließende Strom IG springt hiermit korrespondierend auf einen Maximalwert und fällt sodann sehr schnell von dem Maximalwert auf einen Plateauwert ab. Der Plateauwert wird während des Durchlaufens des Miller-Plateaus beibehalten. Danach fällt der Strom IG exponentiell auf Null ab.

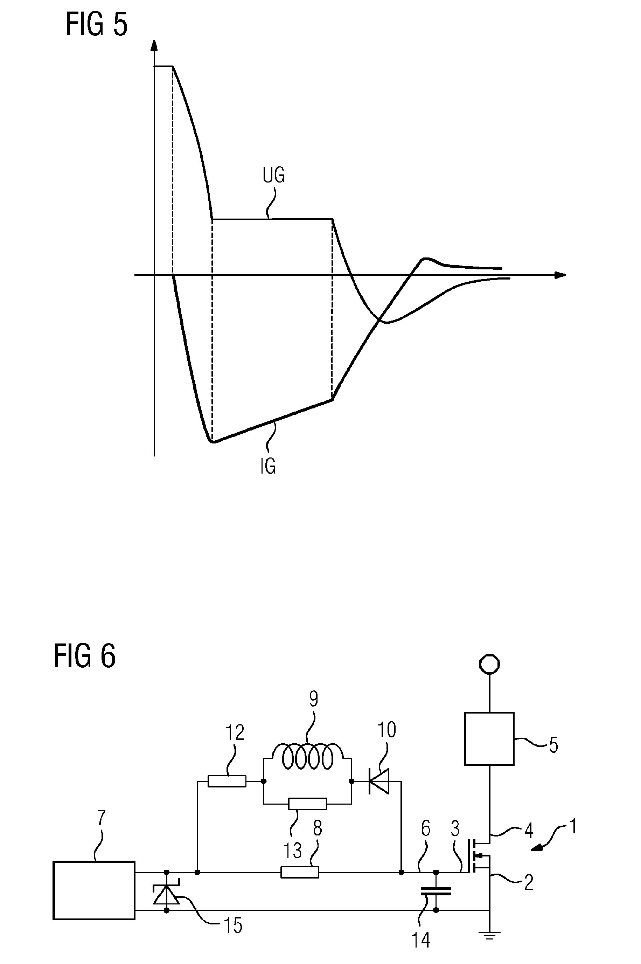

Die Unterschiede zwischen der erfindungsgemäßen Schaltungsanordnung und der Schaltungsanordnung des Standes der Technik zeigen sich beim Ausschalten des Feldeffekttransistors 1. Hierbei wird nachstehend zunächst in Verbindung mit FIG 4 der Spannungs- und Stromverlauf bei der Schaltungsanordnung des Standes der Technik erläutert, danach in Verbindung mit FIG 5 der Spannungs- und Stromverlauf bei der erfindungsgemäßen Schaltungsanordnung.

Entsprechend der Darstellung in FIG 4 fällt bei der Schaltungsanordnung des Standes der Technik die am Gate-Anschluss 3 anstehende Spannung UG sehr schnell auf das Miller-Plateau ab, verharrt dort eine Zeitlang und fällt dann exponentiell auf das Referenzpotenzial ab. Hiermit korrespondierend springt der über die Steuerleitung 6 fließende Strom IG auf einen Minimalwert und steigt sodann sehr schnell von dem Minimalwert auf einen Plateauwert an. Der Plateauwert wird während des Durchlaufens des Miller-Plateaus beibehalten. Danach steigt der Strom IG exponentiell auf Null an. Aufgrund des Umstands, dass die den Strom IG treibende Spannung (d.h. die Differenz zum Referenzpotenzial) beim Ausschalten erheblich kleiner ist als beim Einschalten (dort ist es die Differenz zum Steuerpotenzial) ist der Plateauwert beim Ausschalten betragsmäßig erheblich kleiner als der Plateauwert beim Einschalten. Demzufolge wird entsprechend mehr Zeit benötigt, um die im Gate-Anschluss 3 akkumulierte Ladung abzubauen. Das Ausschalten benötigt daher erheblich mehr Zeit als das Einschalten.

Falls die Steuerschaltung 7 kurzzeitig einen Überstrom verträgt, kann bei der Schaltungsanordnung des Standes der Technik der Zusatzwiderstand 11 unter Umständen entfallen, so dass zusätzlich zum Basiswiderstand 8 lediglich die Diode 10 vorhanden ist. Auch in diesem Fall wird jedoch eine relativ große Zeit zum Abschalten des Feldeffekttransistors 1 benötigt. Denn in diesem Fall wird der Strom IG durch den Innenwiderstand der Steuerschaltung 7 begrenzt und während des Durchlaufens des Miller-Plateaus nur von der bereits recht geringen Potenzialdifferenz getrieben.

Bei der erfindungsgemäßen Schaltungsanordnung fällt entsprechend der Darstellung in FIG 5 die am Gate-Anschluss 3 anstehende Spannung UG ebenfalls sehr schnell auf das Miller-Plateau ab und verharrt dort eine Zeitlang. Danach sinkt die Spannung UG auf ein Minimum ab, das je nach Dimensionierung des Basiswiderstands 8 und der Induktivität 9 sowie der Eigenschaften des Feldeffekttransistors 1 und der Steuerschaltung 7 sogar unter dem Referenzpotenzial liegen kann. Schließlich steigt die Spannung UG langsam auf das Referenzpotenzial an.

Der Strom IG sinkt während des Abfallens der Spannung UG auf das Miller-Plateau allmählich auf einen Maximalwert ab und steigt während des Durchlaufens des Miller-Plateaus langsam an. Sodann steigt der Strom IG rasch auf einen Wert geringfügig über Null an. Das Maximum des Stroms IG wird nach dem Zeitpunkt erreicht, zu dem die Spannung UG ihr Minimum erreicht. Der entscheidende Unterschied des Verlaufs des Stroms IG bei der erfindungsgemäßen Schaltungsanordnung im Vergleich zum Verlauf des Stroms IG bei der Schaltungsanordnung des Standes der Technik besteht darin, dass der durch die Induktivität 9 fließende Anteil des Stromes IG der Spannung UG nacheilt. Während des Durchlaufens des Miller-Plateaus wird daher betragsmäßig im Mittel ein erheblich höherer Strom IG erreicht als im Stand der Technik. Demzufolge erfolgt das Ausschalten des Feldeffekttransistors 1 entsprechend schneller.

Das Diagramm von FIG 5 basiert auf einer Verwendung des Standard-Controllers UCC28C44 mit einer Beschaltung, bei welcher der Basiswiderstand 8 einen Widerstandswert von 100 Ohm aufweist, die Induktivität 9 auf 1 µH dimensioniert ist und der intrinsische Widerstand der Steuerschaltung 7 einen Wert von 5,5 Ohm aufweist.

FIG 6 zeigt eine Modifikation der Schaltungsanordnung von FIG 1. In FIG 6 sind hierbei mehrere Abwandlungen gleichzeitig realisiert. Die Abwandlungen sind jedoch unabhängig voneinander.

Gemäß FIG 6 ist es möglich, dass der Induktivität 9 ein erster Zusatzwiderstand 12 in Reihe geschaltet ist. Alternativ oder zusätzlich ist es möglich, dass der Induktivität 9 ein zweiter Zusatzwiderstand 13 parallelgeschaltet ist. Ebenso alternativ oder zusätzlich ist es möglich, dass der Source-Anschluss 2 und der Gate-Anschluss 3 über einen Kondensator 14 kapazitiv miteinander gekoppelt sind. Der Kondensator 14 ist hierbei zusätzlich zur intrinsischen Kapazität zwischen Source-Anschluss 2 und Gate-Anschluss 3 vorhanden. Schließlich kann unter Umständen der mit der Steuerleitung 6 verbundene Ausgang der Steuerschaltung 7 noch über eine Schottky-Diode 15 mit dem Referenzpotenzial verbunden sein.

Durch den Kondensator 14 kann unter Umständen ein gewisses Resonanzverhalten genutzt werden. Dennoch besteht insbesondere aufgrund des Basiswiderstands 8 keine Gefahr einer durch das Resonanzverhalten bewirkten Instabilität. Die Induktivität 9 wird vielmehr lediglich zur Beeinflussung des zeitlichen Verlaufs des Stromes IG beim Ausschalten des Feldeffekttransistors 1 verwendet.

Zusammengefasst betrifft die vorliegende Erfindung somit folgenden Sachverhalt:
Eine Schaltungsanordnung weist einen Feldeffekttransistor 1 auf, der einen Source-Anschluss 2, einen Gate-Anschluss 3 und einen Drain-Anschluss 4 aufweist. Der Source-Anschluss 2 bildet ein Referenzpotenzial. An den Source-Anschluss 2 oder an den Drain-Anschluss 4 ist eine Nutzlast 5 angeschlossen. Der Gate-Anschluss 3 ist über eine Steuerleitung 6 mit einer Steuerschaltung 7 verbunden. Der Gate-Anschluss 3 wird von der Steuerschaltung 7 über die Steuerleitung 6 alternierend mit dem Referenzpotenzial und einem Steuerpotenzial beaufschlagt. In der Steuerleitung 6 ist ein Basiswiderstand 8 angeordnet. Dem Basiswiderstand 8 ist eine Induktivität 9 derart parallelgeschaltet, dass die Induktivität 9 zumindest dann wirksam ist, wenn der Gate-Anschluss 3 von der Steuerschaltung 7 mit dem Referenzpotenzial beaufschlagt wird.

Die vorliegende Erfindung weist viele Vorteile auf. Insbesondere kann auf einfache und zuverlässige Weise bewirkt werden, dass nicht nur das Einschalten, sondern auch das Ausschalten des Feldeffekttransistors 1 mit hoher Dynamik möglich wird. Insbesondere wird erreicht, dass beim Ausschalten der Strom IG zu Beginn des Miller-Plateaus sein Maximum erreicht und während des Durchlaufens des Miller-Plateaus nur langsam absinkt. Unter Umständen kann sogar erreicht werden, dass der Strom IG beim Ausschalten während des Durchlaufens des Miller-Plateaus größer ist als der Strom, der ohne Induktivität 9 (und auch ohne Zusatzwiderstand 11) erreicht würde. Dennoch wird die Steuerschaltung 7 nicht überlastet. In der Regel wird die Steuerschaltung 7 sogar schwächer belastet als im Stand der Technik. Auch der Feldeffekttransistor 1 selbst wird schwächer belastet als im Stand der Technik, da der Übergang vom durchgeschalteten zum gesperrten Zustand schneller erfolgt.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Schaltungsanordnung mit einem Feldeffekttransistor (1),
- wobei der Feldeffekttransistor (1) einen Source-Anschluss (2), einen Gate-Anschluss (3) und einen Drain-Anschluss (4) aufweist,
- wobei der Source-Anschluss (2) ein Referenzpotenzial bildet, an den Source-Anschluss (2) oder an den Drain-Anschluss (4) eine Nutzlast (5) angeschlossen ist und der Gate-Anschluss (3) über eine Steuerleitung (6) mit einer Steuerschaltung (7) verbunden ist,
- wobei der Gate-Anschluss (3) von der Steuerschaltung (7) über die Steuerleitung (6) alternierend mit dem Referenzpotenzial und einem Steuerpotenzial beaufschlagt wird,
- wobei in der Steuerleitung (6) ein Basiswiderstand (8) angeordnet ist,
**dadurch gekennzeichnet,**
**dass** dem Basiswiderstand (8) eine Induktivität (9) derart parallelgeschaltet ist, dass die Induktivität (9) zumindest dann wirksam ist, wenn der Gate-Anschluss (3) von der Steuerschaltung (7) mit dem Referenzpotenzial beaufschlagt wird.

2. Schaltungsanordnung nach Anspruch 1, **dadurch gekennzeichnet, dass** mit der Induktivität (9) ein weiteres Schaltungselement (10) in Reihe geschaltet ist und dass das weitere Schaltungselement (10) bewirkt, dass die Induktivität (9) ausschließlich dann wirksam ist, wenn der Gate-Anschluss (3) von der Steuerschaltung (7) mit dem Referenzpotenzial beaufschlagt wird.

3. Schaltungsanordnung nach Anspruch 2, **dadurch gekennzeichnet, dass** das weitere Schaltungselement (10) als Diode ausgebildet ist.

4. Schaltungsanordnung nach Anspruch 2, **dadurch gekennzeichnet, dass** das weitere Schaltungselement (10) als Halbleiterschalter ausgebildet ist, dass der Halbleiterschalter von der Steuerschaltung (7) leitend geschaltet wird, wenn der Gate-Anschluss (3) von der Steuerschaltung (7) mit dem Referenzpotenzial beaufschlagt wird, und dass der Halbleiterschalter von der Steuerschaltung (7) nichtleitend geschaltet wird, wenn der Gate-Anschluss (3) von der Steuerschaltung (7) mit dem Steuerpotenzial beaufschlagt wird.

5. Schaltungsanordnung nach einem der obigen Ansprüche, **dadurch gekennzeichnet, dass** der Induktivität (9) ein erster Zusatzwiderstand (12) in Reihe geschaltet ist.

6. Schaltungsanordnung nach einem der obigen Ansprüche, **dadurch gekennzeichnet, dass** der Induktivität (9) ein zweiter Zusatzwiderstand (13) parallelgeschaltet ist.

7. Schaltungsanordnung nach einem der obigen Ansprüche, **dadurch gekennzeichnet, dass** der Source-Anschluss (2) und der Gate-Anschluss (3) über einen Kondensator (14) kapazitiv miteinander gekoppelt sind.
